(19) Europäisches Patentamt
European Patent Office
Office européen des brevets

(11) **EP 4 679 998 A1**

(12) **EUROPEAN PATENT APPLICATION**
published in accordance with Art. 153(4) EPC

(43) Date of publication:
**14.01.2026 Bulletin 2026/03**

(21) Application number: 25767652.8

(22) Date of filing: **03.03.2025**

(51) International Patent Classification (IPC):
*H10N 30/853* (2023.01)   *H03H 9/24* (2006.01)
*H10N 30/06* (2023.01)   *H10N 30/87* (2023.01)

(52) Cooperative Patent Classification (CPC):
H03H 9/24; H10N 30/06; H10N 30/853; H10N 30/87

(86) International application number:
**PCT/JP2025/007570**

(87) International publication number:
**WO 2025/187655 (11.09.2025 Gazette 2025/37)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **04.03.2024 JP 2024031861**

(71) Applicant: National Institute of Advanced
Industrial
Science and Technology
Chiyoda-ku
Tokyo 100-8921 (JP)

(72) Inventors:
• ANGGRAINI, Sri Ayu
Tsukuba-shi, Ibaraki 305-8560 (JP)
• OHMAGARI, Shinya
Tsukuba-shi, Ibaraki 305-8560 (JP)
• HIRATA, Kenji
Tsukuba-shi, Ibaraki 305-8560 (JP)
• UEHARA, Masato
Tsukuba-shi, Ibaraki 305-8560 (JP)
• YAMADA, Hiroshi
Tsukuba-shi, Ibaraki 305-8560 (JP)
• AKIYAMA, Morito
Tsukuba-shi, Ibaraki 305-8560 (JP)

(74) Representative: van Dam, Vincent
Octrooibureau Vriesendorp & Gaade B.V.
Koninginnegracht 19
2514 AB Den Haag (NL)

(54) **PIEZOELECTRIC ELEMENT AND MEMS DEVICE USING SAID PIEZOELECTRIC ELEMENT**

(57) An object is to provide a piezoelectric device that requires no buffer layer, has sufficient piezoelectric property and stability, and can be further miniaturizable in comparison to conventional piezoelectric devices, as well as a MEMS device using the same. A piezoelectric device comprises a piezoelectric body layer 10 consisting of a nitride material having wurtzite crystal structure; a first electrode 20 provided on one side of the piezoelectric body layer; and a second electrode 30 provided on the other side of the piezoelectric body layer, wherein the first electrode consists of a first nitride material having wurtzite crystal structure and an electrical resistivity of 1.0 x $10^{-3}\,\Omega \cdot$ cm or less, and the second electrode consists of a second nitride material having wurtzite crystal structure and an electrical resistivity of 1.0 x $10^{-3}\,\Omega \cdot$ cm or less.

**FIG. 1**

## Description

Technical Field

The present invention relates to a piezoelectric device composed of an electrode and a piezoelectric body both of which consist of a material with wurtzite crystal structure, and a MEMS device using the same.

Background Art

Devices utilizing piezoelectricity are used in a wide range of fields, and in particular, increasingly used in portable devices such as mobile phones for which miniaturization and power-saving are strongly required. One example of such devices is an FBAR filter using a film bulk acoustic resonator.

The FBAR filter is a filter based on a resonator that uses the thickness longitudinal vibration mode of a thin film exhibiting piezoelectric response, with its property enabling resonance in the gigahertz band. The FBAR filter, owing to such a property, is low-loss and can operate over a wide bandwidth, and therefore expected to contribute to further high-frequency compatibility, miniaturization and power saving in portable devices.

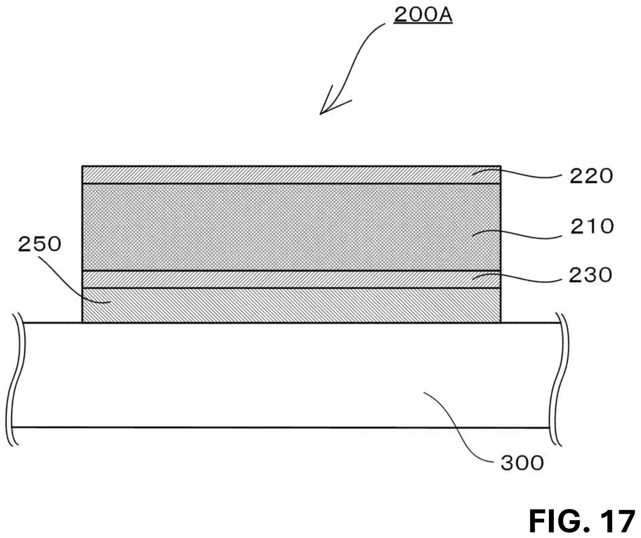

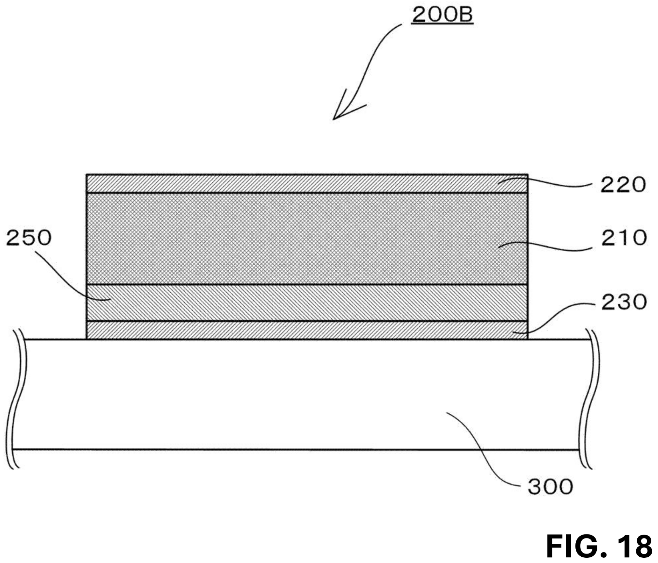

As shown in Figures 17 and 18, conventional piezoelectric devices used in such FBARs, particularly piezoelectric devices 200A and 200B the piezoelectric body layer of which is composed of an wurtzite crystal material, are constructed by stacking a lower electrode 230, a piezoelectric body layer 210 and an upper electrode 220, from bottom to top in this order on a buffer layer 250 provided on a substrate 300 (see Non-Patent Document 1), or by stacking a lower electrode 230, a buffer layer 250, a piezoelectric body layer 210 and an upper electrode 220, from bottom to top in this order on a substrate 300.

Citation List

Non-Patent Literature

Non-Patent Document 1: Moreira et al, Vacuum, 86 (2011) 23

Summary of Invention

Technical Problem

The reason for providing a buffer layer in the above-mentioned conventional piezoelectric device is that by providing a buffer layer, the crystallinity of a piezoelectric body layer provided on the buffer layer can be improved, thereby enabling the formation of the stable piezoelectric body layer.

However, there has been a problem that providing a buffer layer causes an increase in the thickness of the piezoelectric body device, resulting in difficulty to further miniaturize the piezoelectric body device.

In addition, there has also been a problem that the need to form a buffer layer complicated the manufacturing process of piezoelectric devices, resulting in lower productivity and higher production costs.

In view of the above-mentioned circumstances, an object of the present invention is to produce an upper electrode or lower electrode by using an electrode material that is electrically conductive and has wurtzite crystal structure, thereby improving the crystallinity (crystallinity of the wurtzite crystal structure) of a piezoelectric body layer provided (formed) on the upper electrode or the lower electrode, to provide not only a piezoelectric device that requires no buffer layer, has sufficient piezoelectric property and stability, and is further miniaturizable in comparison to conventional piezoelectric devices, but also a MEMS device using the same.

Solution to Problem

The inventor of the present invention, after his intensive research on the above-mentioned problems, have discovered the following innovative piezoelectric device and a MEMS device using the same.

A first aspect of the present invention for solving the above-mentioned problems is a piezoelectric device comprising: a piezoelectric body layer including at least one piezoelectric material layer having wurtzite crystal structure; a first electrode provided on one side of the piezoelectric body layer; and a second electrode provided on the other side of the piezoelectric body layer; wherein at least one of the first electrode and the second electrode consists of a nitride material having wurtzite crystal structure and an electrical resistivity of $1.0 \times 10^{-3} \, \Omega \cdot cm$ or less.

According to this first aspect, by fabricating the first electrode or the second electrode by using a nitride material that is electrically conductive and has wurtzite crystal structure, the crystallinity (crystallinity of the wurtzite crystal structure) of the piezoelectric body layer provided (formed) on the first electrode or the second electrode can be improved. As a result, a piezoelectric device that requires no buffer layer, has sufficient piezoelectric property and stability, and is further miniaturizable in comparison to conventional piezoelectric devices, can be provided.

A second aspect of the present invention is the piezoelectric device according to the first aspect, wherein the first electrode material and the second electrode material consist of a nitride material having wurtzite crystal structure and an electrical resistivity of $1.0 \times 10^{-3} \, \Omega \cdot cm$ or less.

According to this second aspect, since the piezoelectric body layer is also wurtzite crystal, the crystallinity (crystallinity of the wurtzite crystal structure) of the second electrode provided (formed) on the piezoelectric body layer or the first electrode can also be improved. As a result, a piezoelectric device that has better piezoelectric property and stability can be provided.

A third aspect of the present invention is the piezoelectric device according to the first aspect, wherein the nitride material is represented by a chemical formula $A1_{\alpha1}B1_{\beta1}A1_{1-\alpha1-\beta1}N$ or a chemical formula $A1_{\alpha1}B1_{\beta1}Ga_{1-\alpha1-\beta1}N$, $\alpha1$ and $\beta1$ satisfying the following equation (1), or a chemical formula $B2_{\beta2}Al_{1-\beta2}N$ or a chemical formula $B2_{\beta2}Ga_{1-\beta2}N$, $\beta2$ satisfying the following equation (2), and B1 and B2 including a monovalent element,

$$0 < \alpha1/\beta1 < 6 \dots (1),$$

$$0 < \beta2 < 0.52 \dots (2),$$

$(0 < \alpha1 < 1, 0 < \beta1 < 1,$ A1 is at least one of Mg, Zn, Ni, and B1 and B2 are at least one of Au, Ag, Cu).

According to this third aspect, by producing the first electrode or the second electrode by using a nitride material that is more electrically conductive and has wurtzite crystal structure, the crystallinity (crystallinity of the wurtzite crystal structure) of the piezoelectric body layer provided (formed) on the first electrode or the second electrode can be improved. In addition, since the piezoelectric body layer has high crystallinity (crystallinity of the wurtzite crystal structure), the crystallinity (crystallinity of the wurtzite crystal structure) of the second electrode or the first electrode provided (formed) on the piezoelectric body layer can also be improved. As a result, a piezoelectric device that requires no buffer layer, has sufficient piezoelectric property and stability, and is further miniaturizable in comparison to conventional piezoelectric devices, can be provided.

A fourth aspect of the present invention is the piezoelectric device according to the third aspect, wherein monovalent B1 is contained in a greatest amount in comparison to non-monovalent B1, or monovalent B2 is contained in a greatest amount in comparison to non-monovalent B2.

According to this fourth aspect, by producing the first electrode or the second electrode by using a nitride material that is more electrically conductive and has wurtzite crystal structure, the crystallinity (crystallinity of the wurtzite crystal structure) of the piezoelectric body layer provided (formed) on the first electrode or the second electrode can be improved. In addition, since the piezoelectric body layer has high crystallinity (crystallinity of the wurtzite crystal structure), the crystallinity (crystallinity of the wurtzite crystal structure) of the second electrode or the first electrode provided (formed) on the piezoelectric body layer can also be improved. As a result, a piezoelectric device that requires no buffer layer, has sufficient piezoelectric property and stability, and is further miniaturizable in comparison to conventional piezoelectric devices can be provided.

A fifth aspect of the present invention is the piezoelectric device according to Claim 3, wherein $\alpha1$ and $\beta1$ satisfy the following equations (3) and (4),

$$1 \leq \alpha1/\beta1 \leq 5 \dots (3),$$

$$0 < \alpha1 + \beta1 \leq 0.3 \dots (4).$$

According to this fifth aspect, by producing the first electrode or the second electrode by using a nitride material that is more electrically conductive and has wurtzite crystal structure, the crystallinity (crystallinity of the wurtzite crystal structure) of the piezoelectric body layer provided (formed) on the first electrode or the second electrode can be improved. In addition, since the piezoelectric body layer has high crystallinity (crystallinity of the wurtzite crystal structure), the crystallinity (crystallinity of the wurtzite crystal structure) of the second electrode or the first electrode provided (formed) on the piezoelectric body layer can also be improved. As a result, a piezoelectric device that requires no buffer layer, has sufficient piezoelectric property and stability, and is further miniaturizable in comparison to conventional piezoelectric devices can be provided.

A sixth aspect of the present invention is the piezoelectric device according to the first aspect, wherein the Young's modulus of the first electrode and the second electrode is equal to or greater than the Young's modulus of the piezoelectric body layer.

According to this sixth aspect, a piezoelectric device that has a high effective electromechanical coupling coefficient $K_{eff}^2$ can be provided.

A seventh aspect of the present invention is the piezoelectric device according to the first aspect, wherein the thickness t1 of the first electrode, the thickness d of the piezoelectric device, and the thickness t2 of the second electrode satisfy the following equation (5),

$$0.025 \leq (t1 + t2)/d \leq 0.2 \dots (5).$$

According to this seventh aspect, a piezoelectric device that has a higher effective electromechanical coupling coefficient $K_{eff}^2$ can be provided.

An eighth aspect of the present invention is the piezoelectric device according to any one of the first to seventh aspects, wherein the first electrode or the second electrode is provided on the surface of a substrate.

According to this eighth aspect, a piezoelectric device that requires no buffer layer, has sufficient piezoelectric property and stability, and is further miniaturizable in comparison to conventional piezoelectric devices, can be easily manufactured.

The ninth aspect of the present invention is a MEMS device using the piezoelectric device according to the first aspect.

The term "MEMS device" herein refers to any micro electro mechanical system, including, but not limited to, high-frequency filters, physical sensors such as pressure sensors, acceleration sensors, gyro sensors and actuators, microphones, fingerprint authentication sensors, vibration generators, transistors, inverters, transducers, SAW devices, ferroelectric memories, diodes, and batteries.

According to this ninth aspect, further miniaturized MEMS devices can be provided.

Note that the specification of Japanese Patent Application 2024-31861 is incorporated herein by reference as part of this specification.

Brief Description of the Drawings

Figure 1 is a schematic cross-sectional view of a piezoelectric device according to Embodiment 1.

Figure 2 is a table showing the composition of Examples.

Figure 3 is a graph showing a measurement result for Examples 5, 7, and 8 by using an X-ray diffractometer (XRD).

Figure 4 is a graph showing a result of valence measurement for Mg and Au in Examples 1-5 and 1-8.

Figure 5 is a graph showing a result of valence measurement for Mg in $Mg_{0.050}Au_{0.037}Al_{0.913}N$ (top), $Mg_{0.073}Au_{0.036}Al_{0.891}N$ (second from the top), $Mg_{0.101}Au_{0.033}Al_{0.866}N$ (third from the top), and $Mg_{0.388}Au_{0.081}Al_{0.531}N$.

Figure 6 is a graph showing a result of valence measurement for Au in $Mg_{0.050}Au_{0.037}Al_{0.913}N$.

Figure 7 is a table showing the electrical resistivity of the thin film of Examples 1-5, 1-7, 1-8, and 1-13 to 1-27.

Figure 8 is a schematic cross-sectional view of a thin film equivalent to an electrode and a thin film equivalent to a piezoelectric body, prepared to investigate the crystallinity of a semiconductor device.

Figure 9 is a table showing a measurement result of the half-width of rocking curves.

Figure 10 is a graph showing a measurement result of maximum diffraction intensity for the (002) crystallographic plane, obtained while changing the molar ratio of Mg to Au.

Figure 11 is a graph showing a measurement result of maximum diffraction intensity for the (002) crystallographic plane, obtained while changing the Mg + Au value.

Figure 12 is a table showing the composition of Examples 2-1 to 2-11.

Figure 13 is a graph showing a measurement result for Examples 2-1 to 2-3 by using an X-ray diffractometer (XRD).

Figure 14 is a graph showing a result of valence measurement for Au in $Au_{0.02}Al_{0.98}N$.

Figure 15 is table showing the composition and electrical resistivity of Examples 2-5 to 2-11.

Figure 16 shows a graph of a measurement result of maximum diffraction intensity for the (002) crystallographic plane, obtained while changing the Au concentration.

Figure 17 is a schematic cross-sectional view of a conventional piezoelectric device.

Figure 18 is a schematic cross-sectional view of a conventional piezoelectric device.

Description of Embodiments

Now, embodiments of the piezoelectric device according to the present invention and MEMS devices using the same will be described with reference to the attached drawings. Note that the present invention is not limited to the following embodiments.

(Embodiment 1)

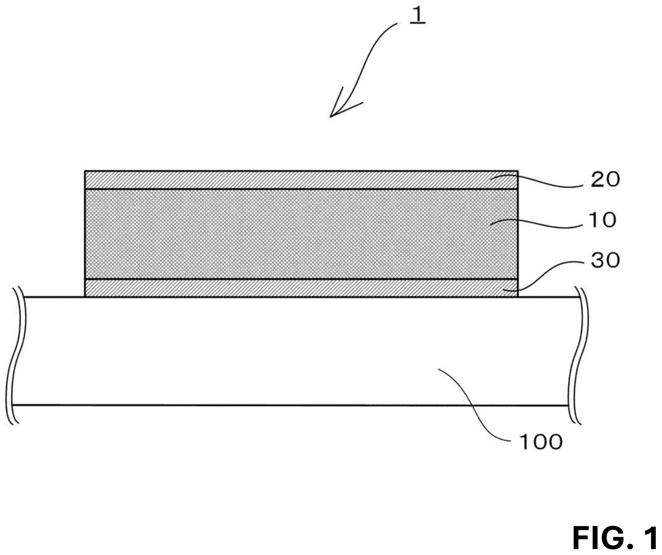

Figure 1 is a schematic cross-sectional view of a piezoelectric device according to this embodiment. As shown in this figure, the piezoelectric device 1 according to this embodiment is provided directly on the surface of the substrate 100 and comprises a second electrode 30 (lower electrode), a piezoelectric body layer 10 provided directly on the upper surface of the second electrode 30, and a first electrode 20 (upper electrode) provided directly on the piezoelectric body layer 10. That is, unlike the above-mentioned conventional piezoelectric device, the piezoelectric device 1 is not provided with any buffer layer. Note that as the terms "first" and "second" used for the electrodes are for convenience of explanation, "first" and "second" can be replaced with each other, not being the term limiting particularly their relative positions.

The piezoelectric body layer 10 is not particularly limited as long as it includes at least one piezoelectric material layer having piezoelectric property and wurtzite crystal structure. That is, the piezoelectric body layer 10 may be composed of a plurality of piezoelectric material layers having wurtzite crystal structure, or it may be composed of a plurality of piezoelectric material layers having wurtzite crystal structure together with a plurality of other piezoelectric body material layers.

Materials composing the piezoelectric material layer used for the piezoelectric body layer 10 are not particularly limited as long as it has piezoelectric property and wurtzite crystal structure. Examples of the materials composing the piezoelectric material layer used for the piezoelectric body layer 10 include AlN, GaN, InN, AlGaN, ScAlN, ScGaN, ScAlGaN, YAlN, YbAlN, YbGaN, YbAlGaN, BAlN, BGaN, BAlGaN, ZnO, LiZnO, and CeMnZnO, as well as a nitride material described in the specifications of Japanese Patent Application No. 2020-212574, a nitride material described in the specifications of Japanese Patent Application No. 2021-027147, a nitride material described in the specifications of Japanese Patent Application No. 2021-501655, a nitride material described in the specification of Japanese Patent Application No. 2023-188952, a nitride material described in the specification of Japanese Patent Application No. 2020-168462, a nitride material described in the specification of Japanese Patent Application No. 2020-168463, a nitride material described in the specification of Japanese Patent Application No. 2018-231681, a nitride material described in the specification of Japanese Patent Application No. 2019-020273, etc. Note that the thickness of the piezoelectric body layer 10 is not particularly limited.

Next, the first electrode 20 and the second electrode 30 will be described. The first electrode 20 is not particularly limited as long as it is a nitride material (first nitride material, first electrode material) having wurtzite crystal structure and an electrical resistivity of $1.0 \times 10^{-3} \, \Omega \cdot \text{cm}$ or less. Note that the electrical resistivity of the first nitride material is preferably $1.47 \times 10^{-6} \, \Omega \cdot \text{cm}$ or more and $1.0 \times 10^{-3} \, \Omega \cdot \text{cm}$ or less, and more preferably $1.47 \times 10^{-6} \, \Omega \cdot \text{cm}$ or more and $1.47 \times 10^{-4} \, \Omega \cdot \text{cm}$ or less.

The first nitride materials include nitride materials represented by a chemical formula $A1_{\alpha1}B1_{\beta1}Al_{1-\alpha1-\beta1}N$ or a chemical formula $A1_{\alpha1}B1_{\beta1}Ga_{1-\alpha1-\beta1}N$, $\alpha1$ and $\beta1$ satisfying the following equation (1), and B1 including a monovalent element,

$$0 < \alpha1/\beta1 < 6 \dots (1).$$

In addition, those containing monovalent B1 in a greatest amount compared to non-monovalent B1 are more preferable. Moreover, $\alpha1$ and $\beta1$ that satisfy the following equations (3) and (4) are more preferable because they lead to less structural mismatch with the piezoelectric body layer 10,

$$1 \le \alpha1/\beta1 \le 5 \dots (3),$$

$$0 < \alpha1 + \beta1 \le 0.3 \dots (4).$$

Note that A1 is at least one of magnesium (Mg), zinc (Zn) and nickel (Ni), or may be any one of these elements or a plurality of these elements. Moreover, B1 is at least one of gold (Au), silver (Ag) and copper (Cu), or may be any one of these elements or a plurality of these elements. Furthermore, when A1 and B1 consists of a plurality of elements, the ratio of these elements is not particularly limited.

For improving the electrical conductivity of a material, a method is generally known which adds (dopes) an element having a smaller valence than that of given elements composing the material. The valence of aluminum and gallium is 3 ($Al^{3+}$, $Ga^{3+}$) in the first nitride material, and when divalent elements ($Mg^{2+}$, $Ca^{2+}$, $Sr^{2+}$, $Ba^{2+}$, $Zn^{2+}$, $Ni^{2+}$, $Pt^{2+}$, $Cd^{2+}$, $Mn^{2+}$, $Ru^{2+}$, $Ir^{2+}$) or monovalent elements ($Li^+$, $Na^+$, $K^+$, $Au^+$, $Ag^+$, $Cu^+$) are added (doped), these elements, according to band theory, act as acceptors, generating an acceptor level immediately above the valence band. As a result, carriers become mobile, leading to improved electrical conductivity (reduced electrical resistivity).

From this, if the electrical resistivity of the first nitride material composed of $Mg_{\alpha1}Au_{\beta1}Al_{1-\alpha1-\beta1}N$, $Zn_{\alpha1}Ag_{\beta1}Al_{1-\alpha1-\beta1}N$, $Mg_{\alpha1}Au_{\beta1}Ga_{1-\alpha1-\beta1}N$, $Mg_{\alpha1}Cu_{\beta1}Ga_{1-\alpha1-\beta1}N$, $Mg_{\alpha1}Ag_{\beta1}Al_{1-\alpha1-\beta1}N$, $Mg_{\alpha1}Cu_{\beta1}Al_{1-\alpha1-\beta1}N$, and $Ni_{\alpha1}Cu_{\beta1}Al_{1-\alpha1-\beta1}N$, is $1.0 \times 10^{-3} \, \Omega \cdot \text{cm}$ or less as will be described below, the electrical resistivity of the first nitride material composed of a combination of other elements in the above-mentioned chemical formula $Al_{\alpha1}B1_{\beta1}Al_{1-\alpha1-\beta1}N$ or chemical formula $A1_{\alpha1}B1_{\beta1}Ga_{1-\alpha1-\beta1}N$ can be estimated to be $1.0 \times 10^{-3} \, \Omega \cdot \text{cm}$ or less.

In addition, the Young's modulus of the first electrode 20 is preferably equal to or greater than the Young's modulus of the piezoelectric body layer 10 because this leads to an increase in the electromechanical coupling coefficient $K_{eff}^2$ of the piezoelectric device 1. Moreover, when the piezoelectric body layer 10 is composed of scandium aluminum nitride, the Young's modulus of the first electrode 20 is more preferably equal to or greater than the Young's modulus of the piezoelectric body layer 10, and 50 GPa or more and 500 GPa or less, and is particularly preferably equal to or greater than the Young's modulus of the piezoelectric body layer 10, and 200 GPa or more and 450 GPa or less. Note that the thickness t1 of the first electrode 20 is not particularly limited.

The second electrode 30 is not particularly limited as long as it is a nitride material (second nitride material, second electrode material) having wurtzite crystal structure and an electrical resistivity of $10^{-3} \, \Omega \cdot \text{cm}$ or less. Note that the electrical resistivity of the second nitride material is, similarly to the that of the first nitride material, preferably $1.47 \times 10^{-6} \, \Omega \cdot \text{cm}$ or more and $1.0 \times 10^{-3} \, \Omega \cdot \text{cm}$ or less, and more preferably $1.47 \times 10^{-6} \, \Omega \cdot \text{cm}$ or more and $1.47 \times 10^{-4} \, \Omega \cdot \text{cm}$ or less.

The second nitride material, similarly to the first nitride material, include a nitride material represented by a chemical formula $A1'_{\alpha1'}B1'_{\beta1'}Al_{1-\alpha1'-\beta1'}N$ or a chemical formula $A1'_{\alpha1'}B1'_{\beta1'}Ga_{1-\alpha1'-\beta1'}N$, $\alpha1'$ and $\beta1'$ satisfying the following equation (6), and B1' including a monovalent element,

$$0 < \alpha1'/\beta1' < 6 \dots (6).$$

In addition, those containing monovalent B1' in a greatest amount compared to non-monovalent B1' are more preferable. Moreover, $\alpha1'$ and $\beta1'$ that satisfy the following equations (7) and (8) are more preferable because they lead to less structural mismatch with the piezoelectric body layer 10,

$$1 \le \alpha1'/\beta1' \le 5 \dots (7),$$

$$0 < \alpha1' + \beta1' \leq 0.3 \ldots (8).$$

Note that A1' is at least one of magnesium (Mg), zinc (Zn) and nickel (Ni), or may be any one of these elements, or a plurality of these elements. Moreover, B1 is at least one of gold (Au), silver (Ag) and copper (Cu), or may be any one of these elements, or a plurality of these elements. Note that when A1' and B1' consists of a plurality of elements, the ratio of those elements is not particularly limited.

If the electrical resistivity of the second nitride material composed of $Mg_{\alpha1'}Au_{\beta1'}Al_{1-\alpha1'-\beta1'}N$, $Zn_{\alpha1'}Ag_{\beta1'}Al_{1-\alpha1'-\beta1'}N$, $Mg_{\alpha1'}Au_{\beta1'}Ga_{1-\alpha1'-\beta1'}N$, $Mg_{\alpha1'}Cu_{\beta1'}Ga_{1-\alpha1'-\beta1'}N$, $Mg_{\alpha1'}Ag_{\beta1'}Al_{1-\alpha1-\beta1'}N$, $Mg_{\alpha1'}Cu_{\beta1'}Al_{1-\alpha1'-\beta1'}N$ and $Ni_{\alpha1'}Cu_{\beta1'}Al_{1-\alpha1'-\beta1'}N$ is, similarly to that of the first electrode 20, 1.0 x $10^{-3}$ $\Omega \cdot$ cm or less, the electrical resistivity of the second nitride material composed of a combination of other elements in the above-mentioned chemical formula $A1'_{\alpha1}B1'_{\beta1}Al_{1-\alpha1'-\beta1'}N$ or chemical formula $A1'_{\alpha1}B1'_{\beta1}Ga_{1-\alpha1'-\beta1'}N$ can be estimated to be 1.0 x $10^{-3}$ $\Omega \cdot$ cm or less.

Furthermore, the Young's modulus of the second electrode 30 is, similarly to the first electrode 20, preferably equal to or greater than that of the piezoelectric body layer 10 because this leads to an increase in the electromechanical coupling coefficient $K_{eff}^2$. Note that the thickness t2 of the second electrode 30 is not particularly limited.

The first nitride material and the second nitride material may be composed of the same nitride material or composed of different nitride materials. Furthermore, the first nitride material and the second nitride material may be composed of the same nitride material, and their respective thicknesses may be the same (t1 = t2).

Note that for the piezoelectric device 1 that satisfies the above equations (1), (3), (4), and (6) to (8), since the second electrode 30 has higher crystallinity (wurtzite crystal structure crystallinity), the crystallinity (wurtzite crystal structure crystallinity) of the piezoelectric body layer 10 provided (formed) on the second electrode 30 can be further improved. Moreover, since the piezoelectric body layer 10 has higher crystallinity (crystallinity of the wurtzite crystal structure), the crystallinity (crystallinity of the wurtzite crystal structure) of the first electrode 20 provided (formed) on the piezoelectric body layer 10 can also be further improved. As a result, a piezoelectric device having such a structure requires no buffer layer, has sufficient piezoelectric property and high stability, and is further miniaturizable in comparison to conventional piezoelectric devices.

Not that the piezoelectric device according to the present invention, including the present embodiment, can be manufactured by known manufacturing methods.

By constituting the piezoelectric device 1 as described above, the crystallinity (the crystallinity of the wurtzite crystal) of the piezoelectric body layer 10 provided (formed) on the electrode can be improved by using a nitride material having wurtzite crystal structure to fabricate the electrode (first electrode 20 or second electrode 30). Moreover, since the piezoelectric body layer 10 is a wurtzite crystal, the crystallinity (crystallinity of the wurtzite crystal structure crystallinity) of the second electrode 30 or first electrode 20 provided (formed) on the piezoelectric body layer 10 can also be improved. As a result, a piezoelectric device that requires no buffer layer, has sufficient piezoelectric property and stability, and is further miniaturizable in comparison to conventional piezoelectric devices, can be provided.

<Example of Electrode>

Using the following apparatus and sputtering targets, and so on, thin films of nitride material containing additive magnesium, zinc or nickel (A1 = Mg, Zn or Ni), and gold, silver or copper (B1 = Au, Ag or Cu) ($Mg_{\alpha1}Au_{\beta1}Al_{1-\alpha1-\beta1}N$, $Zn_{\alpha1}Ag_{\beta1}Al_{1-\alpha1^-\beta1}N$, $Mg_{\alpha1}Au_{\beta1-}Ga_{1-\alpha1-\beta1}N$, $Mg_{\alpha1}Cu_{\beta1}Ga_{1-\alpha-\beta1}N$, $Mg_{\alpha1}Ag_{\beta1}Al_{1-\alpha1-\beta1}N$, $Mg_{\alpha1}Cu_{\beta1}Al_{1-\alpha1-\beta1}N$ and $Ni_{\alpha1}Cu_{\beta1}Al_{1-\alpha1-\beta1}N$), thickness of which was 0.05-2 $\mu$m, were prepared on an n-type silicon substrate having a specific electrical resistance (electrical resistivity) of 0.02 $\Omega \cdot$ cm.

Multi-target simultaneous sputtering deposition system (manufactured by Kenix Co., Ltd.)
Magnesium sputtering target material (purity: 99.99%)
Zinc sputtering target material (purity: 99.9%)
Nickel sputtering target material (purity: 99.9%)
Gold sputtering target material (purity: 99.9%)
Silver sputtering target material (purity: 99.9%)
Copper sputtering target material (purity: 99.9%)
Aluminum sputtering target material (purity: 99.999%)
Gallium nitride sputtering target material (purity: 99.99%)
Gas: Gas mixture of nitrogen (purity: 99.99995% or higher) and argon gas (purity: 99.9999% or higher) (mixing ratio (nitrogen : argon) 30 : 70)
Substrate heating temperature: 500°C

The film deposition experiment was performed after evacuating a sputtering chamber to a high vacuum of $10^{-5}$ Pa or less using a vacuum pump. Also, to prevent contamination by impurities such as oxygen, the target surface was cleaned immediately after target installation and immediately before each film deposition experiment.

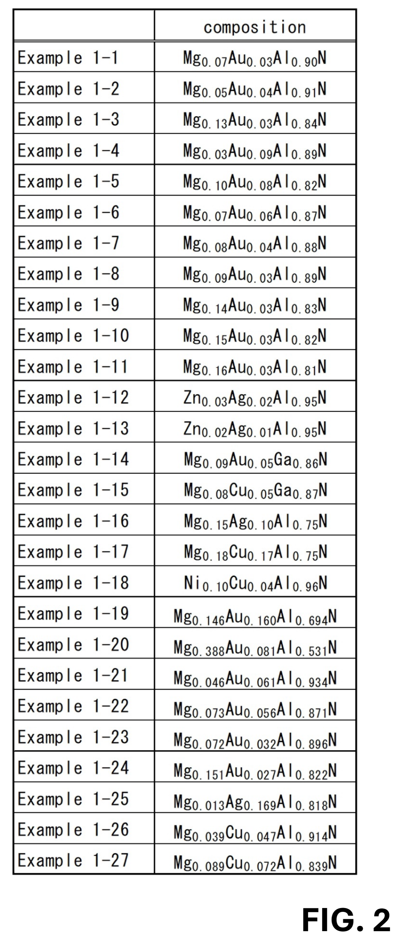

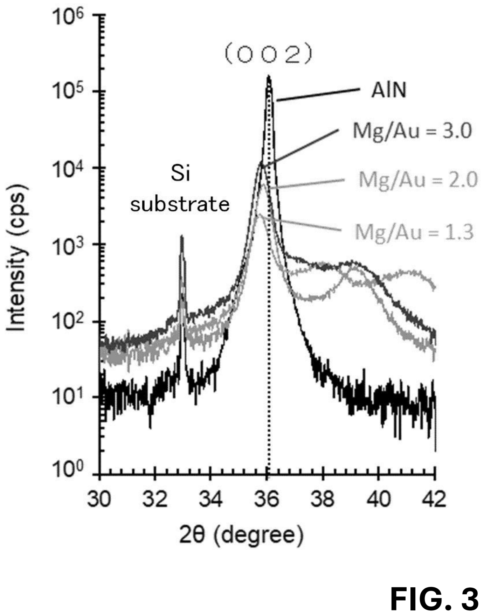

Figure 2 shows the composition of respective thin films of nitride material obtained, and Figure 3 shows a measurement result for Examples 1-5, 1-7 and 1-8 by using an X-ray diffractometer (XRD). As can be seen from this figure, the respective aluminum nitride thin films obtained were found to have wurtzite crystal structure.

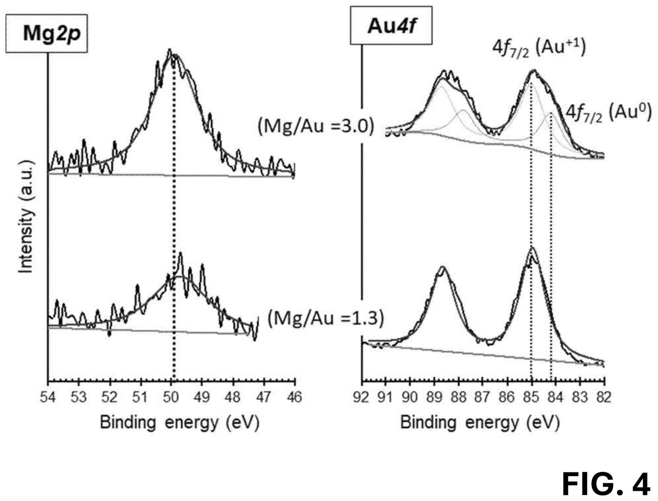

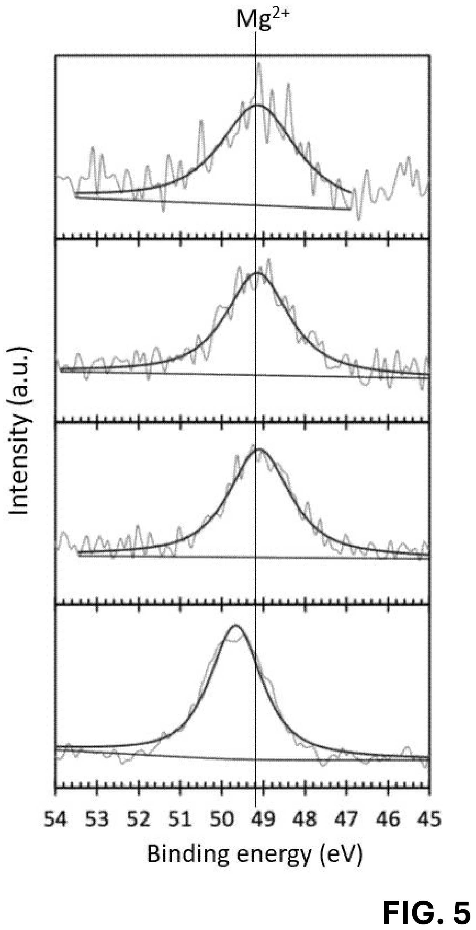

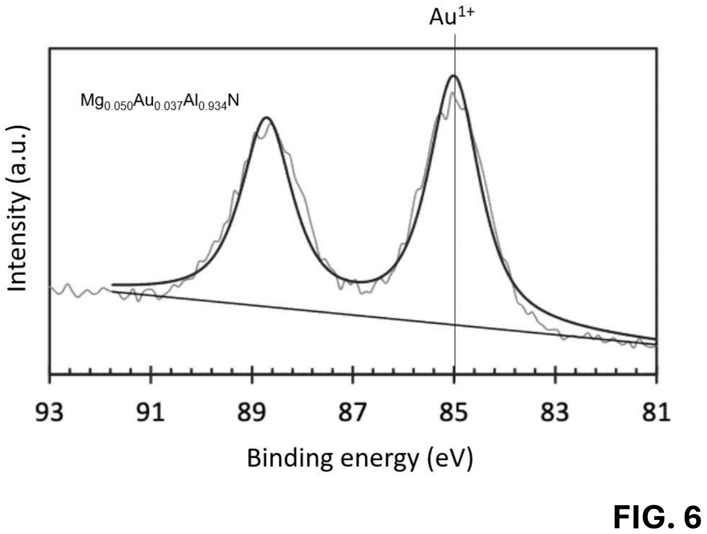

Next, Figure 4 shows a result of valence measurement for Mg and Au in Examples 1-5 and 1-8 using an X-ray photoelectron spectroscopy (XPS) device. Also, Figure 5 shows a result of valence measurement for Mg in $Mg_{0.050}Au_{0.037}Al_{0.913}N$ (top row), $Mg_{0.073}Au_{0.036}Al_{0.891}N$ (second row from top), $Mg_{0.101}Au_{0.033}Al_{0.866}N$ (third row from top), and $Mg_{0.388}Au_{0.081}Al_{0.531}N$ (bottom row) using the X-ray diffractometer (XRD), and Figure 6 shows a result of valence measurement for Au in $Mg_{0.050}Au_{0.037}Al_{0.913}N$. The peak shown in these figures indicates the binding energy of each of the elements. From Figures 4 and 5, the binding energy of Mg 2p was found to match that of Mg having a valence of 2 (+2). Similarly, from Figures 4 and 6, the binding energy of Au 4f was found to match that of Au having a valence of 1 (+1). Therefore, the valence of Mg contained in the thin film of Examples 1-5 and 1-8, as well as in $Mg_{0.050}Au_{0.037}Al_{0.913}N$ and $Mg_{0.101}Au_{0.033}Al_{0.866}N$ was found to be 2 (+2), and Au having a valence (valency) of 1 (+1) contained in the thin film of Examples 1-5 and 1-8, as well as $Mg_{0.050}Au_{0.037}Al_{0.913}N$ was found to be in an greater amount than Au having a valence of zero ($Au^{0}$) contained therein.

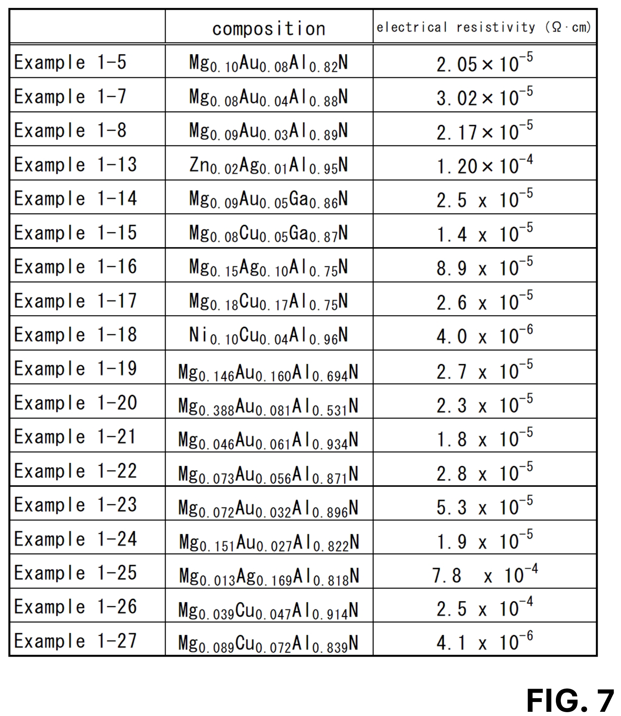

Also, the electrical resistivity of the thin film of Examples 1-5, 1-7, 1-8, and 1-13 to 1-27 was measured using a specific electrical resistance/Hall measurement system (Resist Test 8300: manufactured by Toyo Technica Co., Ltd.). Figure 7 shows the result. As can be seen from this figure, the electrical resistivity of the obtained nitride thin films was found to be $7.8 \times 10^{-4} \, \Omega \cdot cm$ or less, and to be $1.47 \times 10^{-4} \, \Omega \cdot cm$ or less except for Examples 1-25 and 1-26.

<Crystallinity of Semiconductor Device>

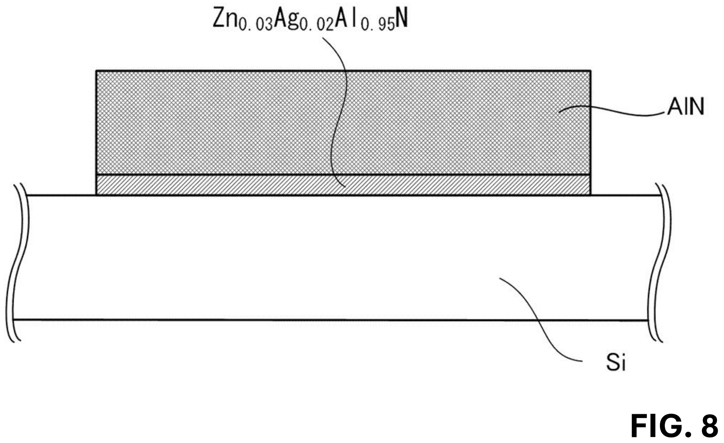

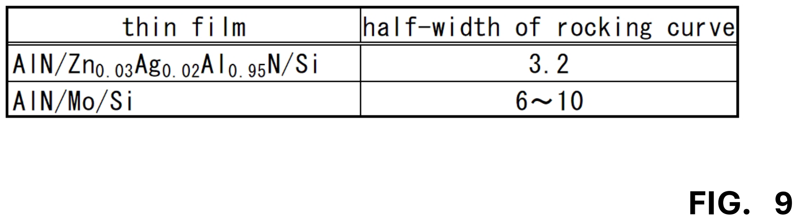

As shown in Figure 8, on a silicon substrate, a $Zn_{0.03}Ag_{0.02}Al_{0.95}N$ thin film corresponding to the second electrode was fabricated, on which an AlN thin film corresponding to the piezoelectric body layer was formed. Then, using an X-ray diffractometer (manufactured by Rigaku Corporation), the half-width of the rocking curve for the (002) crystallographic plane of the $Zn_{0.03}Ag_{0.02}Al_{0.95}N$ thin film and of the AlN thin film was measured. Figure 9 shows the result.

As can be seen from this figure, the half-width of the rocking curve of the AlN thin film corresponding to the piezoelectric body layer was found to be sufficiently small. That is, a piezoelectric body layer having high wurtzite crystallinity was found to be able to be formed even without any buffer layer.

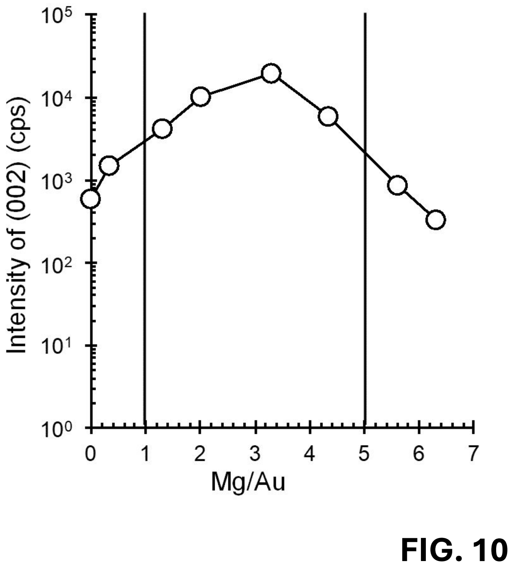

Next, Figure 10 shows a measurement result of maximum diffraction intensity for the (002) crystallographic plane using the X-ray diffractometer (XRD), obtained while changing the molar ratio ($\alpha1/\beta1$) of Mg and Au in the aluminum nitride thin film ($Mg_{\alpha1}Au_{\beta1}Al_{1-\alpha1-\beta1}N$). As can be seen from this figure, the aluminum nitride thin film was found to have wurtzite crystal structure when the ratio was within the range of $0 < \alpha1/\beta1 < 6$, and highly crystallized wurtzite crystal structure when within the range of $1 \leq \alpha/\beta \leq 5$.

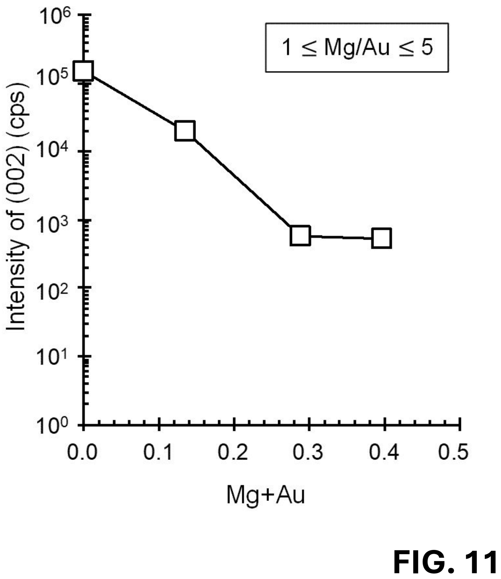

Also, an aluminum nitride thin film ($Mg^{2+}_{\alpha1}Au_{1+\beta1}Al_{1-\alpha1-\beta1}N$) was prepared while changing the value of $\alpha1 + \beta1$ within the range of $1 \leq \alpha1/\beta1 \leq 5$. Figure 11 shows a measurement result of maximum diffraction intensity for the (002) crystallographic plane of each aluminum nitride thin film using the X-ray diffractometer (XRD).

From this figure, the aluminum nitride thin film satisfying the range of $0 < \alpha1 + \beta1 < 0.3$ was found to have highly crystallized wurtzite crystal structure. Note that, although it is difficult to discern from this figure, the maximum diffraction intensity for the (002) crystallographic plane of the aluminum nitride thin film at $\alpha1 + \beta1 = 0.3$ is greater than at $\alpha1 + \beta1 = 0.4$.

(Embodiment 2)

In Embodiment 1, aluminum nitride (AlN) and gallium nitride (GaN) both doped with two elements were used as the first electrode material and the second electrode material, but the present invention is not limited thereto. For example, aluminum nitride doped with only one element or gallium nitride doped with only one element may be used as the first electrode material and the second electrode material.

Specifically, the first electrode materials include, for example, those represented by a chemical formula $B2_{\beta2}Al_{1-\beta2}N$ or a chemical formula $B2_{\beta2}Ga_{1-\beta2}N$, $\beta2$ satisfying the following equation (2), and B2 including a monovalent element,

$$0 < \beta2 < 0.52 \ldots (2).$$

Note that $\beta2$ is more preferably within the range of $0 < \beta2 < 0.2$.

Moreover, the electrode material containing the highest ratio of a monovalent B2 in comparison to non-monovalent B2 is more preferable.

Note that that B2 is at least one of gold (Au), silver (Ag) and copper (Cu), and may be any one of these elements or a plurality of these elements. Moreover, when B2 consists of a plurality of elements, the ratio of these elements is not particularly limited.

The second electrode materials include, similarly to the first electrode material, for example, those represented by a chemical formula $B2'_{\beta2'}Al_{1-\beta2'}N$ or a chemical formula $B2'_{\beta2'}Ga_{1-\beta2'}N$, $\beta2'$ satisfying the following equation (9), and B2' including a monovalent element,

$$0 < \beta2' < 0.52 \ldots (9).$$

Note that $\beta2'$ is more preferably within the range of $0 < \beta2' < 0.2$.

Moreover, the electrode material containing the highest proportion of monovalent B2' in comparison to a non-monovalent B2' is more preferable.

Note that B2' is at least one of gold (Au), silver (Ag) and copper (Cu), and may be any one of these elements, or a plurality of these elements. Moreover, when B2' consists of a plurality of elements, the ratio of those elements is not particularly limited. Even if such an electrode material is used to construct a piezoelectric device, the same effects as in Embodiment 1 can be achieved.

<Example of Electrode>

Using the following apparatus and sputtering targets, and so on, a thin film of nitride material containing additive gold or copper (B2 = Au, Cu), thickness of which was 0.05-2 $\mu$m, was prepared on an n-type silicon substrate with a specific electrical resistance (electrical resistivity) of 0.02 $\Omega \cdot$ cm.

Multi-target simultaneous sputtering deposition system (manufactured by Kenix Co., Ltd.)
Gold sputtering target material (purity: 99.9%)
Copper sputtering target material (purity: 99.9%)
Aluminum sputtering target material (purity: 99.999%)
Gallium nitride sputtering target material (purity: 99.99%)
Gas: Gas mixture of nitrogen (purity: 99.99995% or higher) and argon gas (purity: 99.9999% or higher) (mixing ratio (nitrogen : argon) 30 : 70)
Substrate heating temperature: 500°C

The film deposition experiment was performed after evacuating a sputtering chamber to a high vacuum of $10^{-5}$ Pa or less using a vacuum pump. Also, to prevent contamination by impurities such as oxygen, the target surface was cleaned immediately after target installation and immediately before each film deposition experiment.

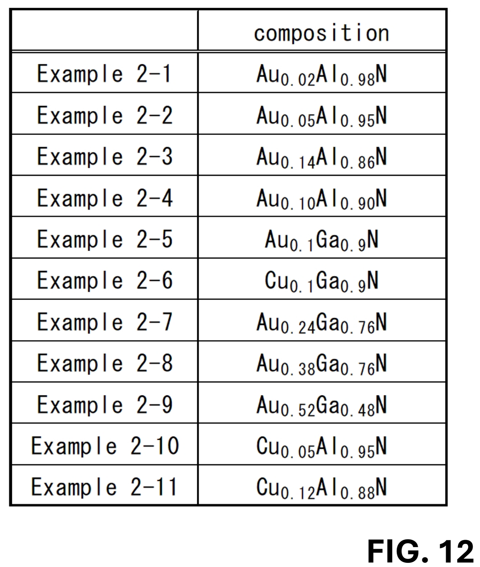

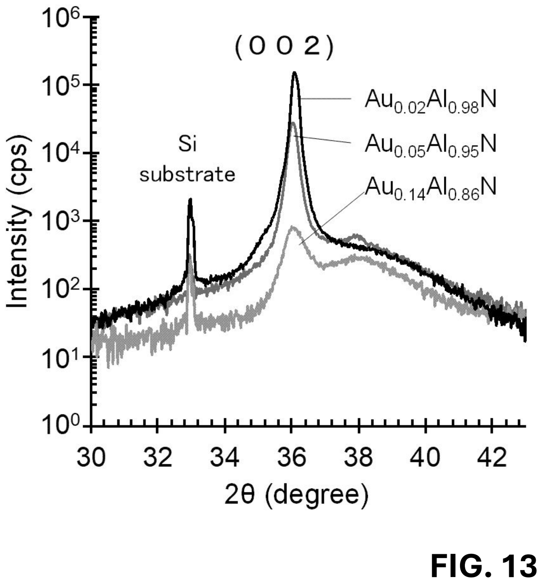

Figure 12 shows the composition of respective thin films of nitride material obtained, and Figure 13 shows a measurement result for Examples 2-1 to 2-3 using the X-ray diffractometer (XRD). As can be seen from this figure, respective aluminum nitride thin films obtained in Examples 2-1 to 2-3 were found to have wurtzite crystal structure.

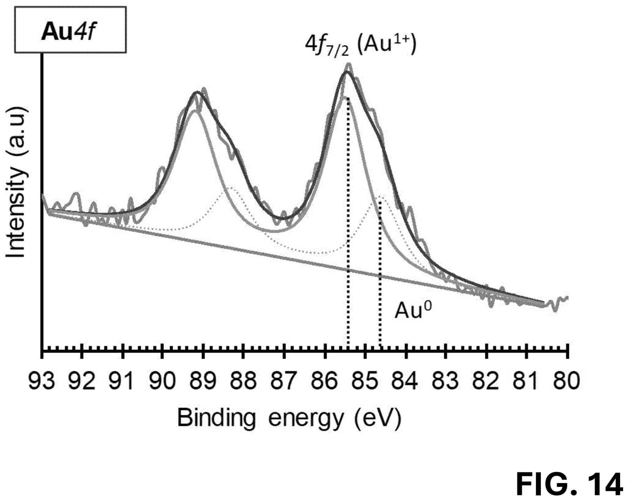

Next, Figure 14 shows the result of valence measurement for Au in $Au_{0.02}Al_{0.98}N$ using an X-ray photoelectron spectroscopy (XPS) device. The peak shown in this figure indicates the binding energy of each of the elements. The binding energy of Au 4f was found to match that of Au having a valence of 1 (+1). Therefore, Au having a valence (valency) of 1 (+1) contained in the $Au_{0.02}Al_{0.98}N$ thin film was found to be in a greater amount than Au having a valence of zero ($Au^0$) contained therein.

Furthermore, the electrical resistivity of the thin film of Example 2-4 ($Au_{0.10}Al_{0.90}N$) was measured using a specific electrical resistance/Hall measurement system (manufactured by Toyo Technica Co., Ltd.), which was $5.48 \times 10^{-4}$ $\Omega \cdot$ cm.

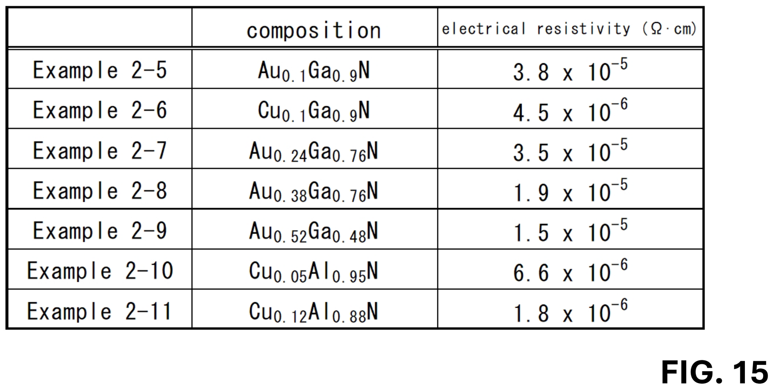

Also, the electrical resistivity of the thin film of Examples 2-5 to 2-11 was measured using a specific electrical resistance/Hall measurement system (Resist Test 8300: manufactured by Toyo Technica Co., Ltd.). Figure 15 shows the result. From this figure, the electrical resistivity of Examples 2-5 to 2-11 was found to be less than $1.0 \times 10^{-3}$ $\Omega \cdot$ cm.

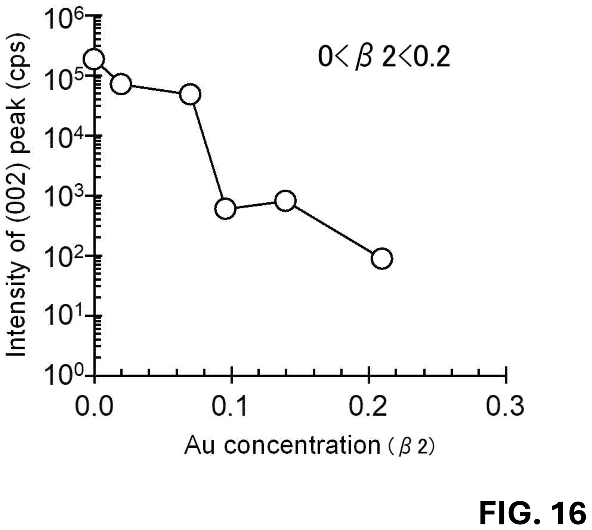

Next, Figure 16 shows a measurement result of maximum diffraction intensity for the (002) crystallographic plane using an X-ray diffractometer (XRD), obtained while changing Au concentration in the aluminum nitride thin film ($Au_{\beta2}Al_{1-\beta2}N$). As can be seen from this figure, the aluminum nitride thin film was found to have wurtzite crystal structure when the concentration was within the range of $0 < \beta2 < 0.2$.

(Embodiment 3)

In Embodiments 1 and 2, the first electrode and the second electrode were composed using the above-mentioned nitride materials, but the present invention is not limited thereto. For example, either the first electrode or the second electrode may be composed using a known electrode material. Examples of the electrode material are not particularly limited, and include Pt, etc.

(Other Embodiments)

In Embodiment 1, although the thickness of the piezoelectric device was not limited, it may be limited. Specifically, the piezoelectric device may be configured such that the thickness t1 of the first electrode, the thickness t2 of the second electrode, and the thickness d of the piezoelectric device satisfy the following equation (5),

$$0.025 \leq (t1 + t2) / d \leq 0.2 \dots (5).$$

A piezoelectric device configured in this manner has a high electromechanical coupling coefficient $K_{eff}^2$.

Note that the piezoelectric device, of course, can be fabricated using the above-mentioned first electrode and second electrode. Again, note that a MEMS device can be also fabricated using the piezoelectric device.

Reference Signs List

1, 200A, 200B Piezoelectric device
10, 210 Piezoelectric layer
20, 220 First electrode
30, 230 Second electrode
100, 300 Substrate
250 Buffer layer

**Claims**

1.  A piezoelectric device comprising:

    a piezoelectric body layer including at least one piezoelectric material layer having wurtzite crystal structure;
    a first electrode provided on one side of said piezoelectric body layer; and
    a second electrode provided on the other side of said piezoelectric body layer;

    wherein at least one of said first electrode and said second electrode consists of a nitride material having wurtzite crystal structure and an electrical resistivity of $1.0 \times 10^{-3}$ $\Omega \cdot$ cm or less.

2.  The piezoelectric device according to Claim 1, wherein said first electrode material and said second electrode material consist of said nitride material having wurtzite crystal structure and an electrical resistivity of $1.0 \times 10^{-3}$ $\Omega \cdot$ cm or less.

3.  The piezoelectric device according to Claim 1 or 2,

    wherein said nitride material is represented by a chemical formula $Al_{\alpha 1}B1_{\beta 1}Al_{1-\alpha 1-\beta 1}N$ or a chemical formula $Al_{\alpha 1}Bl_{\beta 1}Ga_{1-\alpha 1-\beta 1}N$, $\alpha 1$ and $\beta 1$ satisfying the following equation (1),
    or
    a chemical formula $B2_{\beta 2}Al_{1-\beta 2}N$ or a chemical formula $B2_{\beta 2}Ga_{1-\beta 2}N$, $\beta 2$ satisfying the following equation (2),
    and B1 and B2 including a monovalent element,

    $$0 < \alpha 1/\beta 1 < 6 \ldots (1),$$

    $$0 < \beta 2 < 0.52 \ldots (2),$$

    ($0 < \alpha 1 < 1$, $0 < \beta 1 < 1$, A1 is at least one of Mg, Zn, Ni, and B1 and B2 are at least one of Au, Ag, Cu).

4.  The piezoelectric device according to Claim 3, wherein monovalent B1 is contained in a greatest amount compared to non-monovalent B1, or monovalent B2 is contained in a greatest amount compared to non-monovalent B2.

5.  The piezoelectric device according to in Claim 3, wherein $\alpha 1$ and $\beta 1$ satisfy the following equations (3) and (4),

    $$1 \le \alpha 1/\beta 1 \le 5 \ldots (3),$$

    $$0 < \alpha 1 + \beta 1 \le 0.3 \ldots (4).$$

6.  A piezoelectric device according to Claim 1, wherein the Young's modulus of said first electrode and said second electrode is equal to or greater than the Young's modulus of said piezoelectric body layer.

7.  The piezoelectric device according to Claim 1, wherein the thickness t1 of said first electrode, the thickness d of said piezoelectric device, and the thickness t2 of said second electrode satisfy the following equation (5),

    $$0.025 \le (t1 + t2)/d \le 0.2 \ldots (5).$$

8.  The piezoelectric device according to Claim 1, wherein said first electrode or said second electrode is provided on the surface of a substrate.

9.  A MEMS device using the piezoelectric device according to Claim 1.

FIG. 1

| | composition |
|---|---|
| Example 1-1 | $Mg_{0.07}Au_{0.03}Al_{0.90}N$ |
| Example 1-2 | $Mg_{0.05}Au_{0.04}Al_{0.91}N$ |
| Example 1-3 | $Mg_{0.13}Au_{0.03}Al_{0.84}N$ |
| Example 1-4 | $Mg_{0.03}Au_{0.09}Al_{0.89}N$ |
| Example 1-5 | $Mg_{0.10}Au_{0.08}Al_{0.82}N$ |
| Example 1-6 | $Mg_{0.07}Au_{0.06}Al_{0.87}N$ |
| Example 1-7 | $Mg_{0.08}Au_{0.04}Al_{0.88}N$ |
| Example 1-8 | $Mg_{0.09}Au_{0.03}Al_{0.89}N$ |
| Example 1-9 | $Mg_{0.14}Au_{0.03}Al_{0.83}N$ |
| Example 1-10 | $Mg_{0.15}Au_{0.03}Al_{0.82}N$ |
| Example 1-11 | $Mg_{0.16}Au_{0.03}Al_{0.81}N$ |
| Example 1-12 | $Zn_{0.03}Ag_{0.02}Al_{0.95}N$ |
| Example 1-13 | $Zn_{0.02}Ag_{0.01}Al_{0.95}N$ |
| Example 1-14 | $Mg_{0.09}Au_{0.05}Ga_{0.86}N$ |
| Example 1-15 | $Mg_{0.08}Cu_{0.05}Ga_{0.87}N$ |
| Example 1-16 | $Mg_{0.15}Ag_{0.10}Al_{0.75}N$ |
| Example 1-17 | $Mg_{0.18}Cu_{0.17}Al_{0.75}N$ |
| Example 1-18 | $Ni_{0.10}Cu_{0.04}Al_{0.96}N$ |
| Example 1-19 | $Mg_{0.146}Au_{0.160}Al_{0.694}N$ |
| Example 1-20 | $Mg_{0.388}Au_{0.081}Al_{0.531}N$ |
| Example 1-21 | $Mg_{0.046}Au_{0.061}Al_{0.934}N$ |
| Example 1-22 | $Mg_{0.073}Au_{0.056}Al_{0.871}N$ |
| Example 1-23 | $Mg_{0.072}Au_{0.032}Al_{0.896}N$ |
| Example 1-24 | $Mg_{0.151}Au_{0.027}Al_{0.822}N$ |
| Example 1-25 | $Mg_{0.013}Ag_{0.169}Al_{0.818}N$ |
| Example 1-26 | $Mg_{0.039}Cu_{0.047}Al_{0.914}N$ |
| Example 1-27 | $Mg_{0.089}Cu_{0.072}Al_{0.839}N$ |

**FIG. 2**

**FIG. 3**

FIG. 4

**FIG. 5**

**FIG. 6**

EP 4 679 998 A1

| | composition | electrical resistivity ($\Omega \cdot$ cm) |
|---|---|---|
| Example 1-5 | $Mg_{0.10}Au_{0.08}Al_{0.82}N$ | $2.05 \times 10^{-5}$ |
| Example 1-7 | $Mg_{0.08}Au_{0.04}Al_{0.88}N$ | $3.02 \times 10^{-5}$ |
| Example 1-8 | $Mg_{0.09}Au_{0.03}Al_{0.89}N$ | $2.17 \times 10^{-5}$ |
| Example 1-13 | $Zn_{0.02}Ag_{0.01}Al_{0.95}N$ | $1.20 \times 10^{-4}$ |
| Example 1-14 | $Mg_{0.09}Au_{0.05}Ga_{0.86}N$ | $2.5 \times 10^{-5}$ |
| Example 1-15 | $Mg_{0.08}Cu_{0.05}Ga_{0.87}N$ | $1.4 \times 10^{-5}$ |
| Example 1-16 | $Mg_{0.15}Ag_{0.10}Al_{0.75}N$ | $8.9 \times 10^{-5}$ |
| Example 1-17 | $Mg_{0.18}Cu_{0.17}Al_{0.75}N$ | $2.6 \times 10^{-5}$ |
| Example 1-18 | $Ni_{0.10}Cu_{0.04}Al_{0.96}N$ | $4.0 \times 10^{-6}$ |
| Example 1-19 | $Mg_{0.146}Au_{0.160}Al_{0.694}N$ | $2.7 \times 10^{-5}$ |
| Example 1-20 | $Mg_{0.388}Au_{0.081}Al_{0.531}N$ | $2.3 \times 10^{-5}$ |
| Example 1-21 | $Mg_{0.046}Au_{0.061}Al_{0.934}N$ | $1.8 \times 10^{-5}$ |
| Example 1-22 | $Mg_{0.073}Au_{0.056}Al_{0.871}N$ | $2.8 \times 10^{-5}$ |
| Example 1-23 | $Mg_{0.072}Au_{0.032}Al_{0.896}N$ | $5.3 \times 10^{-5}$ |
| Example 1-24 | $Mg_{0.151}Au_{0.027}Al_{0.822}N$ | $1.9 \times 10^{-5}$ |
| Example 1-25 | $Mg_{0.013}Ag_{0.169}Al_{0.818}N$ | $7.8 \times 10^{-4}$ |
| Example 1-26 | $Mg_{0.039}Cu_{0.047}Al_{0.914}N$ | $2.5 \times 10^{-4}$ |
| Example 1-27 | $Mg_{0.089}Cu_{0.072}Al_{0.839}N$ | $4.1 \times 10^{-6}$ |

**FIG. 7**

$Zn_{0.03}Ag_{0.02}Al_{0.95}N$

AlN

Si

**FIG. 8**

EP 4 679 998 A1

| thin film | half-width of rocking curve |
|---|---|
| $AlN/Zn_{0.03}Ag_{0.02}Al_{0.95}N/Si$ | 3.2 |
| $AlN/Mo/Si$ | 6～10 |

**FIG. 9**

EP 4 679 998 A1

**FIG. 10**

FIG. 11

|  | composition |
|---|---|
| Example 2-1 | $Au_{0.02}Al_{0.98}N$ |
| Example 2-2 | $Au_{0.05}Al_{0.95}N$ |
| Example 2-3 | $Au_{0.14}Al_{0.86}N$ |
| Example 2-4 | $Au_{0.10}Al_{0.90}N$ |
| Example 2-5 | $Au_{0.1}Ga_{0.9}N$ |
| Example 2-6 | $Cu_{0.1}Ga_{0.9}N$ |
| Example 2-7 | $Au_{0.24}Ga_{0.76}N$ |
| Example 2-8 | $Au_{0.38}Ga_{0.76}N$ |
| Example 2-9 | $Au_{0.52}Ga_{0.48}N$ |
| Example 2-10 | $Cu_{0.05}Al_{0.95}N$ |
| Example 2-11 | $Cu_{0.12}Al_{0.88}N$ |

# FIG. 12

FIG. 13

FIG. 14

| | composition | electrical resistivity ($\Omega \cdot cm$) |
|---|---|---|
| Example 2-5 | $Au_{0.1}Ga_{0.9}N$ | $3.8 \times 10^{-5}$ |
| Example 2-6 | $Cu_{0.1}Ga_{0.9}N$ | $4.5 \times 10^{-6}$ |
| Example 2-7 | $Au_{0.24}Ga_{0.76}N$ | $3.5 \times 10^{-5}$ |
| Example 2-8 | $Au_{0.38}Ga_{0.76}N$ | $1.9 \times 10^{-5}$ |
| Example 2-9 | $Au_{0.52}Ga_{0.48}N$ | $1.5 \times 10^{-5}$ |
| Example 2-10 | $Cu_{0.05}Al_{0.95}N$ | $6.6 \times 10^{-6}$ |
| Example 2-11 | $Cu_{0.12}Al_{0.88}N$ | $1.8 \times 10^{-6}$ |

**FIG. 15**

**FIG. 16**

EP 4 679 998 A1

FIG. 17

FIG. 18

## INTERNATIONAL SEARCH REPORT

International application No.

**PCT/JP2025/007570**

### A. CLASSIFICATION OF SUBJECT MATTER

*H10N 30/853*(2023.01)i; *H03H 9/24*(2006.01)i; *H10N 30/06*(2023.01)i; *H10N 30/87*(2023.01)i
FI:   H10N30/853; H10N30/87; H10N30/06; H03H9/24 A

According to International Patent Classification (IPC) or to both national classification and IPC

### B. FIELDS SEARCHED

Minimum documentation searched (classification system followed by classification symbols)

H10N30/853; H03H9/24; H10N30/06; H10N30/87

Documentation searched other than minimum documentation to the extent that such documents are included in the fields searched

Published examined utility model applications of Japan 1922-1996
Published unexamined utility model applications of Japan 1971-2025
Registered utility model specifications of Japan 1996-2025
Published registered utility model applications of Japan 1994-2025

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | WO 2022/163722 A1 (NITTO DENKO CORPORATION) 04 August 2022 (2022-08-04) paragraphs [0015]-[0017], fig. 1-6 | 1-9 |
| A | JP 2020-57781 A (NITTO DENKO CORPORATION) 09 April 2020 (2020-04-09) paragraphs [0024], [0029]-[0032], fig. 1-7 | 1-9 |
| A | WO 2023/223815 A1 (AGC INC.) 23 November 2023 (2023-11-23) paragraphs [0019]-[0025], fig. 1 | 1-9 |
| A | WO 2018/135178 A1 (MURATA MANUFACTURING CO., LTD.) 26 July 2018 (2018-07-26) paragraphs [0018]-[0022], fig. 1-4 | 1-9 |

☐ Further documents are listed in the continuation of Box C.       ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **31 March 2025** | **08 April 2025** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**
**Information on patent family members**

International application No.

**PCT/JP2025/007570**

| Patent document cited in search report | | | Publication date (day/month/year) | Patent family member(s) | Publication date (day/month/year) |
|---|---|---|---|---|---|
| WO | 2022/163722 | A1 | 04 August 2022 | (Family: none) | |
| JP | 2020-57781 | A | 09 April 2020 | US 2021/0399202 A1 paragraphs [0029], [0034]-[0037], fig. 1-7 WO 2020/067330 A1 EP 3859799 A1 | |
| WO | 2023/223815 | A1 | 23 November 2023 | (Family: none) | |
| WO | 2018/135178 | A1 | 26 July 2018 | US 2019/0280181 A1 paragraphs [0023]-[0027], fig. 1-4 | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2024031861 A
- JP 2020212574 A
- JP 2021027147 A
- JP 2021501655 A
- JP 2023188952 A
- JP 2020168462 A
- JP 2020168463 A
- JP 2018231681 A
- JP 2019020273 A

**Non-patent literature cited in the description**

- **MOREIRA et al.** *Vacuum*, 2011, vol. 86, 23